# EUROPEAN PATENT APPLICATION

(11) **EP 4 585 485 A1**
(43) Date of publication of application: **16.07.2025**
(21) Application number: 23871541.1
(22) Date of filing: 16.08.2023
(51) Int. Cl.: B61B 3/02, B61B 13/00, B65G 1/00

(54) **OVERHEAD CONVEYANCE VEHICLE**

(30) Priority: 29.09.2022 JP 2022156046
(71) Applicant: Murata Machinery, Ltd., Kyoto-shi, Kyoto 601-8326 (JP)
(72) Inventor: TORAZAWA, Masayoshi, Inuyama-shi, Aichi 484-8502 (JP)
(74) Representative: Hoffmann Eitle
(86) International application number: PCT/JP2023/029634
(87) International publication number: WO 2024/070299

(57) **Abstract**

The overhead transport vehicle includes: a traveling cart configured to travel on a track; a body part provided in a swivelable manner with respect to the traveling cart; a transfer device provided in the body part and provided to be capable of feeding an article in a horizontal direction; and an obstacle sensor provided in a manner of not overlapping a direction in which the transfer device feeds the article in the body part, and configured to detect an obstacle located ahead in a travel direction of the traveling cart.

## Description

### Technical Field

One aspect of the present disclosure relates to overhead transport vehicles.

### Background Art

Overhead transport vehicles are known including a traveling cart traveling along a track, and a body part that is connected to the traveling cart and is disposed below the track. These overhead transport vehicles are provided with obstacle sensors detecting obstacles that become obstacle during travel. For example, an overhead transport vehicle described in Patent document 1 is connected below a traveling cart and is provided with a transfer device that is swivelable with respect to the traveling cart. The obstacle sensor is attached to a lower end of a support member extending downward from the traveling cart, the support member being disposed in part of the circumference of the transfer device.

### Citation List

### Patent Literature

[Patent document 1] Japanese Patent No. 7040637

### Summary of Invention

### Technical Problem

However, in the conventional overhead transport vehicle described above, support members are provided to part of a circumference of the transfer device, so even if the transfer device is provided in a swivelable manner to the traveling cart, it is not possible to feed (move horizontally) an article in a direction in which the support member is disposed, limiting a transfer position to which transferring can be performed.

Therefore, an object of one aspect of the present disclosure is to provide an overhead transport vehicle capable of increasing the degree of freedom of a transfer position of an article by a transfer device.

### Solution to Problem

The overhead transport vehicle according to one aspect of the present disclosure includes: a traveling cart configured to travel on a track; a body part provided in a swivelable manner with respect to the traveling cart; a transfer device provided in the body part and provided to be capable of feeding an article in a horizontal direction; and an obstacle sensor provided in a manner of not overlapping a direction in which the transfer device feeds the article in the body part, and configured to detect an obstacle located ahead in a travel direction of the traveling cart.

In the overhead transport vehicle with this configuration, the obstacle sensor and the transfer device swivel in unison when the body part swivel with respect to the traveling cart, and the position of the obstacle sensor does not overlap with the direction in which the transfer device feeds the article. This eliminates the presence of a support member for attaching the obstacle sensor to the traveling cart in the direction in which the article is fed from the transfer device. As a result, the transfer device becomes capable of feeding articles in any direction, and thus increases the degree of freedom of the transfer position of the article by the transfer device.

In the overhead transport vehicle according to one aspect of the present disclosure, in the track in which a plurality of first rails extending in a first direction and a plurality of second rails extending in a second direction orthogonal to the first direction are disposed in a grid pattern, the traveling cart may move in the first direction by traveling on the pair of first rails adjacent to each other in the second direction, and may move in the second direction by traveling on the pair of second rails adjacent to each other in the first direction. In this configuration, it is possible to increase the degree of freedom of the transfer position of the article by the transfer device while increasing the degree of freedom of the travel direction by the traveling cart.

The overhead transport vehicle according to one aspect of the present disclosure may further include a control section configured to swivel the body part so that a detection area of the obstacle sensor faces forward in a travel direction of the traveling cart when the traveling cart starts traveling. In this configuration, no matter where the obstacle sensor is installed in the body part, the obstacle sensor can detect an obstacle located ahead in the travel direction of the overhead transport vehicle when the overhead transport vehicle is traveling.

The obstacle sensor of the overhead transport vehicle according to one aspect of the present disclosure may include: a first sensor disposed to be capable of detecting the obstacle on one side of the body part in a predetermined direction; and a second sensor disposed to be capable of detecting the obstacle on the other side in the predetermined direction, and the control section may swivel, according to a travel direction when the traveling cart starts traveling, the body part so that a detection area of one of the first sensor and the second sensor is directed forward in the travel direction of the traveling cart, and may disable detection of the obstacle in the other of the first sensor and the second sensor. In this configuration in which two obstacle sensors are provided in the body part, compared to when only one obstacle sensor is provided in the body part, the time required to swivel the body part so that the detection area of the obstacle sensor faces forward in the travel direction of the traveling cart can be shortened.

In the overhead transport vehicle according to one aspect of the present disclosure, the control section may determine which one of the detection areas of the first sensor and the second sensor to be directed forward in a travel direction of the traveling cart, based on information about in which direction orthogonal to the travel direction the article is transferred at a next transfer point. In this configuration, the time required for swiveling for transfer after arriving at the next transfer point can be shortened.

### Advantageous Effects of Invention

According to one aspect of the present disclosure, the degree of freedom of the transfer position of an article by the transfer device can be increased.

### Brief Description of Drawings

[FIG. 1] FIG. 1 is a perspective view illustrating an example of a transport vehicle system according to an embodiment.
[FIG. 2] FIG. 2 is an exploded perspective view illustrating four rail units constituting a rail assembly in FIG. 1 and a connecting member configured to link those rail units together.
[FIG. 3] FIG. 3 is a side view of an overhead transport vehicle in FIG. 1 viewed from an X direction.
[FIG. 4] FIG. 4 is a perspective view illustrating the overhead transport vehicle in FIG. 1 viewed from diagonally upward.
[FIG. 5] FIG. 5 is a perspective view illustrating only a rail portion of the rail assembly.
[FIG. 6] FIG. 6 is a sectional view illustrating a connecting part between a plurality of the rail units.
[FIG. 7] FIG. 7 is a perspective view illustrating the overhead transport vehicle in FIG. 1 viewed from diagonally downward.
[FIG. 8] FIG. 8 is a side view of the overhead transport vehicle in FIG. 1 viewed from a Y direction.
[FIG. 9] FIG. 9 is a block diagram illustrating a functional configuration of the overhead transport vehicle system according to the embodiment.

### Description of Embodiments

The following describes the embodiments of the present disclosure with reference to the drawings. In the description of the drawings, identical elements are marked with the same symbol and redundant explanations are omitted. In the drawings, for convenience of explanation, each configuration according to the embodiment is represented at a different scale as appropriate. In some drawings, the XYZ Cartesian coordinate system is also shown. In the following description, this coordinate system will be referred to for ease of explanation. Hereafter, one direction along a horizontal plane is an X direction (first direction), a direction orthogonal to the X direction and along the horizontal plane is a Y direction (second direction), and a vertical direction is a Z direction.

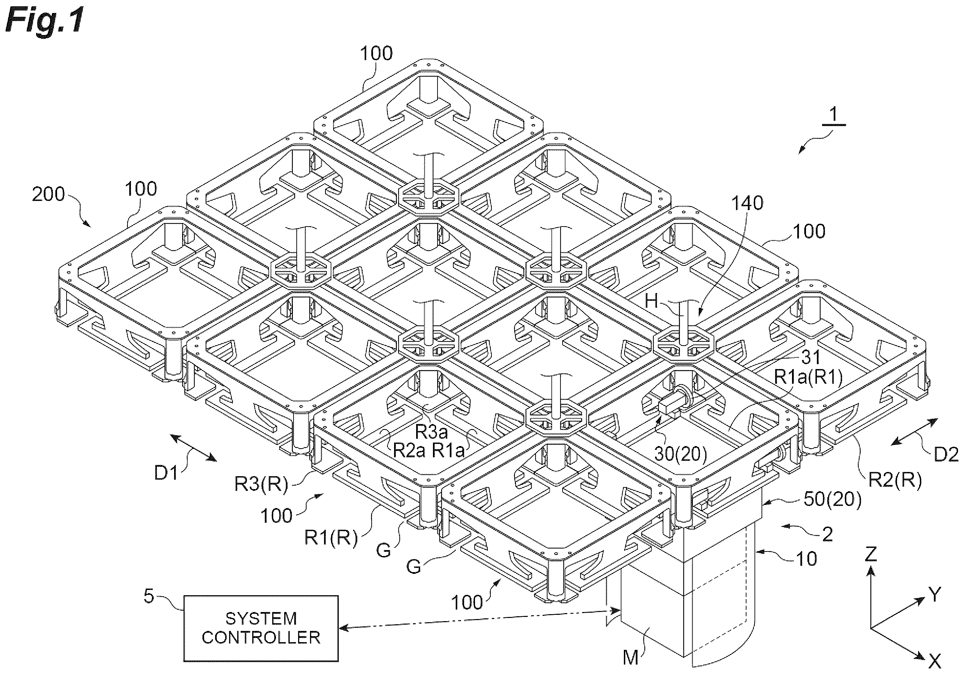

As illustrated in FIG. 1, the overhead transport vehicle system 1 according to the embodiment is a grid system (transport system or tracked cart system) for transporting an article M by means of an overhead transport vehicle 2 in a clean room of a semiconductor manufacturing plant, for example. The overhead transport vehicle system 1, for example, has a plurality of the overhead transport vehicles 2 (hereinafter collectively referred to as " transport vehicles 2"), a system controller 5 configured to control the transport vehicles 2, and a track R on which a plurality of the transport vehicles 2 travel. The transport vehicles 2 move along the track R of the overhead transport vehicle system 1. The transport vehicles 2 run along the track R and transport the article M, such as a FOUP (Front Opening Unified Pod) configured to house semiconductor wafers, a reticle Pod configured to house reticles, or the like. The transport vehicles 2 each may be referred to as a cart, a transport vehicle, a transport cart, a traveling cart, or the like. The transport vehicles 2 enable high-density transportation of the articles M and increase the transport efficiency of the articles M. The overhead transport vehicle system 1 may also include only one transport vehicle 2.

The track R is provided on or near the ceiling of a clean room or other building. The track R is provided adjacent to, for example, processing equipment, a stocker (automatic warehouse), or the like. The processing equipment includes, for example, exposure equipment, coater developers, deposition equipment, etching equipment, or the like, the processing equipment applying various types of processing to the semiconductor wafers in the articles M transported by the transport vehicles 2. The stocker stores the articles M to be transported by the transport vehicle 2.

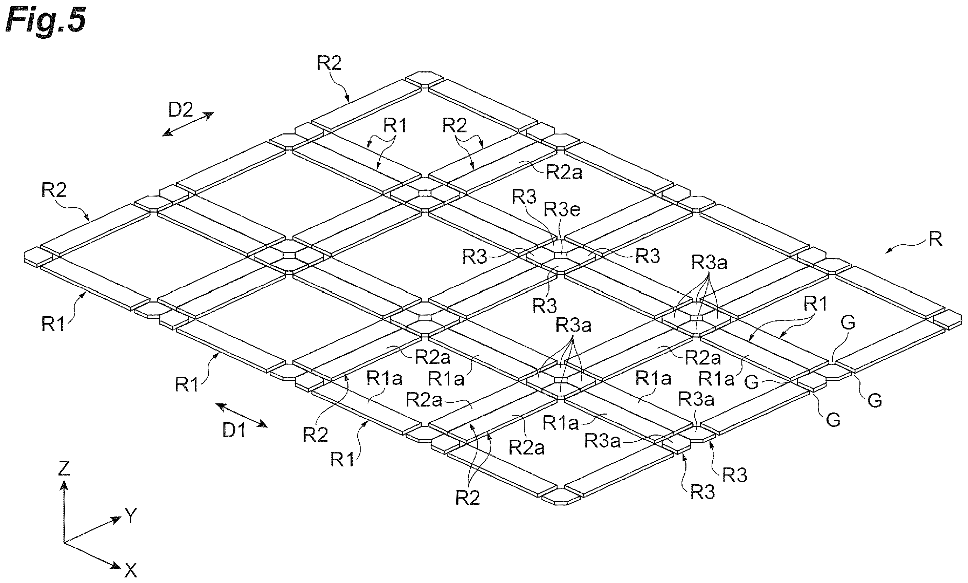

The tracks R are arranged in a grid in plan view (see also FIG. 5). The track R extends along the horizontal direction. In the present embodiment, the track R is constructed by a plurality of rail units 100 each including a first rail R1, a second rail R2, and an intersection rail R3, the rail units 100 being provided side by side in the X direction and in the Y direction. The overhead transport vehicle system 1 includes the rail units 100 provided side by side in the X direction and in the Y direction, and a plurality of connecting members 140 each configured to connect the rail units 100 to each other. The rail units 100 and the connecting members 140 form a rail assembly 200. The rail assembly 200 is hanged from an unillustrated ceiling or the like by a plurality of hanging members H at a portion where the rail units 100 are connected to each other by the connecting members 140.

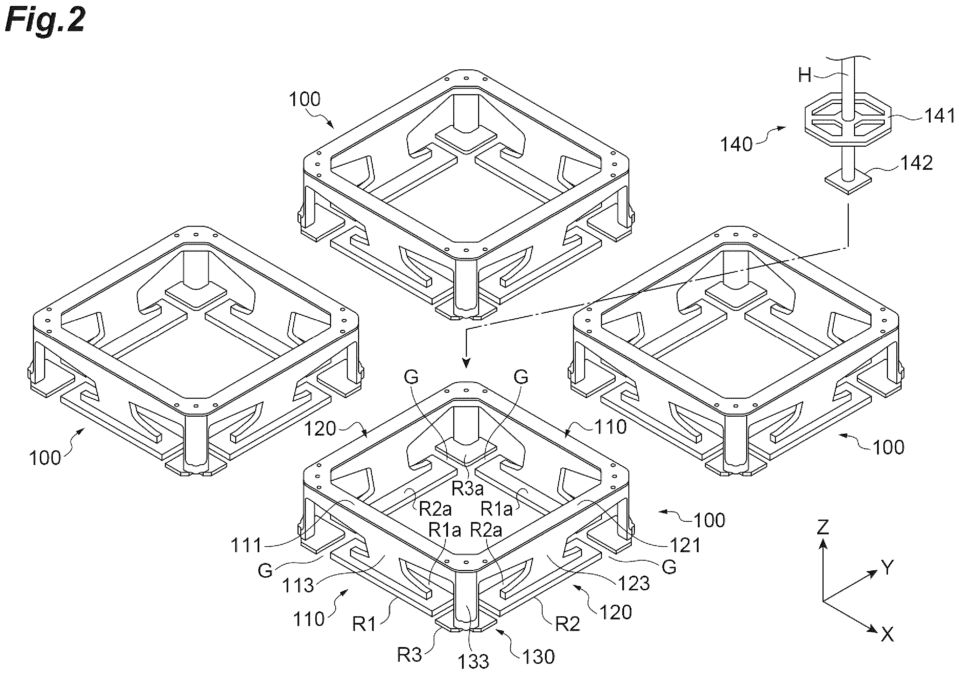

FIG. 2 is an exploded perspective view of the four rail units 100 constituting the rail assembly 200 in FIG. 1 and the connecting member 140 configured to connect those rail units 100. Each of the rail units 100 is a member of a rectangular shape (frame shape) and has the same configuration. Each rail unit 100 includes two first rail members 110 disposed along the X direction, two second rail members 120 disposed along the Y direction, and four intersection rail members 130 disposed such that gaps are formed on extensions of the first rail member 110 and the second rail member 120 (i.e., at the intersection of the grid). When the rail unit 100 is viewed in plan view, the two parallel first rail members 110 and the two parallel second rail members 120 are disposed in a square shape, and the four intersection rail members 130 are disposed at the apexes of the square.

Each rail unit 100 is made of metal, for example, and is a unit in which the first rail member 110, the second rail member 120, and the intersection rail member 130 are integrated after each thereof is molded. Each of the first rail members 110 includes a first beam portion 111 disposed at an upper end position of the rail unit 100 and extending in the X direction, a first rail (travel rail) R1 disposed at a lower end position of the rail unit 100 and extending in the X direction, and a first support wall 113 disposed between the first beam portion 111 and the first rail R1, and joined to the first beam portion 111 and the first rail R1. Each of the second rail members 120 includes a second beam portion 121 disposed at the upper end position of the rail unit 100 and extending in the Y direction, a second rail (travel rail) R2 disposed at the lower end position of the rail unit 100 and extending in the Y direction, and a second support wall 123 disposed between the second beam portion 121 and the second rail R2 and joined to the second beam portion 121 and the second rail R2. A plurality of the first beam portions 111 and a plurality of the second beam portions 121 form a grid structure, the structure extending along an XY plane at the upper end position of the rail assembly 200. The first support wall 113 extends along the XZ plane. The second support wall 123 extends along the YZ plane.

The intersection rail member 130 includes an intersection support column 133 extending along the Z direction (vertical direction) at the position where the first beam portion 111 and the second beam portion 121 are joined at right angles, and an intersection rail R3 at a lower end of the intersection support column 133.

As illustrated in FIG. 1 and FIG. 5, a plurality of the first rails R1 each extend along the X direction. A plurality of the second rails R2 each extend along the Y direction. The track R is formed in a grid in plan view by the first rails R1 and the second rails R2. The track R is formed in a plurality of squares by the first rails R1 and the second rails R2. The intersection rail R3 is disposed at a portion corresponding to the intersection between the first rail R1 and the second rail R2. The intersection rail R3 is adjacent to the first rail R1 at an interval each other in an X direction. The intersection rail R3 is adjacent to the second rail R2 at an interval each other in the Y direction. The intersection rail R3 is used in every case when the transport vehicle 2 travels along the first rail R1, when the transport vehicle 2 travels along the second rail R2, or when the transport vehicle 2 travels from the first rail R1 to the second rail R2 or from the second rail R2 to the first rail R1.

Each rail unit 100 forms a track R of a square shape (or a rectangular shape) corresponding to a single square in its interior thereof. When the rail units 100 are aligned in the X direction and the Y direction, the first rails R1 extend in a series in the X direction and the second rails R2 extend in a series in the Y direction. The two intersection rails R3 are disposed at intervals between one first rail R1 and another first rail R1 on the X direction line. On the Y direction line, the two intersection rails R3 are disposed at intervals between the one second rail R2 and another second rail R2. The track R is described in another viewpoint. When focusing on the four squares made of two squares aligned in the X direction and two squares aligned in the Y direction, the four intersection rails R3 adjacent to each other in the X direction and the Y direction are disposed at intervals (with respect to the first rail R1) between the two first rails R1 adjacent to each other in the Y direction and another two first rails R1 adjacent to each other in the Y direction. The same four intersection rails R3 as above are disposed at intervals (with respect to the second rail R2) between the two second rails R2 adjust each other in the X direction and another two second rails R2 adjacent to each other in the X direction.

In a rail assembly 200, the first rails R1, the second rails R2, and the intersection rails R3 are disposed at intervals from each other, and thereby a track R is constructed. A gap G corresponding to the above interval is formed between each first rail R1 and the corresponding intersection rail R3. A gap G corresponding to the above interval is formed between each second rail R2 and the corresponding intersection rail R3. The gap G in the track R has a constant size. Each of the first rails R1 includes a first travel surface R1a of being flat and horizontal on its upper surface, and the traveling wheel 31 of the transport vehicle 2 travels on the first travel surface R1a in the X direction (first traveling direction D1). Each of the second rails R2 includes a second travel surface R2a of being flat and horizontal on its upper surface, and the traveling wheel 31 of the transport vehicle 2 travels on the second travel surface R2a in the Y direction (second traveling direction D2). The intersection rail R3 includes an intersection travel surface R3a of being flat and horizontal on its upper surface. The heights of the first travel surface R1a, the second travel surface R2a, and the intersection travel surface R3a are equal throughout the entire track R. The first travel surface R1a, the second travel surface R2a, and the intersection travel surface R3a are disposed on the same or substantially the same horizontal plane.

For example, there is no gap having a size of the gap G formed between the four intersection rails R3 described above. When the transport vehicle 2 passes in a straight line through the rail units 100, the traveling wheel 31 of the transport vehicle 2 travels on the intersection travel surface R3a. During the traveling, the traveling wheel 31 passes over any two of the four intersection rails R3 described above. Alternatively, when the transport vehicle 2 changes the traveling direction between the rail units 100 (changes the traveling direction by 90 degrees, i.e., turns), the traveling wheel 31 of the transport vehicle 2 passes over the intersection travel surface R3a (while changing the direction).

As described above, in the rail assembly 200, a first rail member 110, a second rail member 120, and a intersection rail member 130 constitute a track R in a grid. The layout of the track R configured in a grid in the overhead transport vehicle system 1 may be adjusted or modified as appropriate by providing a plurality of rail units 100 in any desired arrangement (including adding or deleting of the rail unit 100).

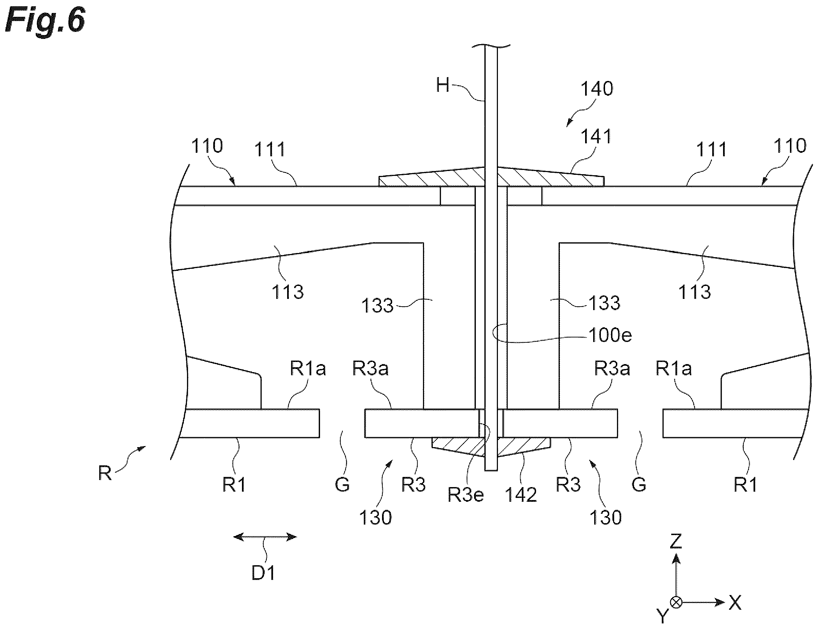

Referring to FIGs. 2 and 6, the connection structure of the rail unit 100 with the connecting member 140 is described. As illustrated in FIGs. 2 and 6, each of the connecting members 140 includes an upper connecting member 141 and a lower connecting member 142. The upper surface of any one of the four corners of the plurality of (typically four) rail units 100 is attached to an upper connecting member 141 of a plate shape or a frame shape extending horizontally. The upper connecting member 141 is in contact with near the intersection of the first beam portion 111 and the second beam portion 121 in each of the rail units 100. The lower connecting member 142 of a plate shape or a frame shape extending horizontally supports the lower surface of any one of the four corners of the plurality of (typically four) rail units 100. The lower connecting member 142 is in contact with the intersection rail R3 in each of the rail units 100.

A hanging member H of a bar shape extending in the vertical direction penetrates through the upper connecting member 141 and the lower connecting member 142. The upper connecting member 141 and/or the lower connecting member 142 are fixed to the rail unit 100 by an unillustrated fastening member or the like, and thereby the rail units 100 are connected to each other. Note that a space 100e extending in the Z direction is formed between the rail units 100, and a space R3e extending in the Z direction is formed between the four intersection rails R3 adjacent to each other in the X and Y directions (center portion in plan view). The hanging member H is inserted into the space 100e and the space R3e, and the upper connecting member 141 and/or the lower connecting member 142 are fixed to the hanging member H.

The overhead transport vehicle system 1 includes a communication system (not illustrated). The communication system is used for communication between the transport vehicle 2 and the system controller 5. The transport vehicle 2 and the system controller 5 are each communicatively connected via a communication system.

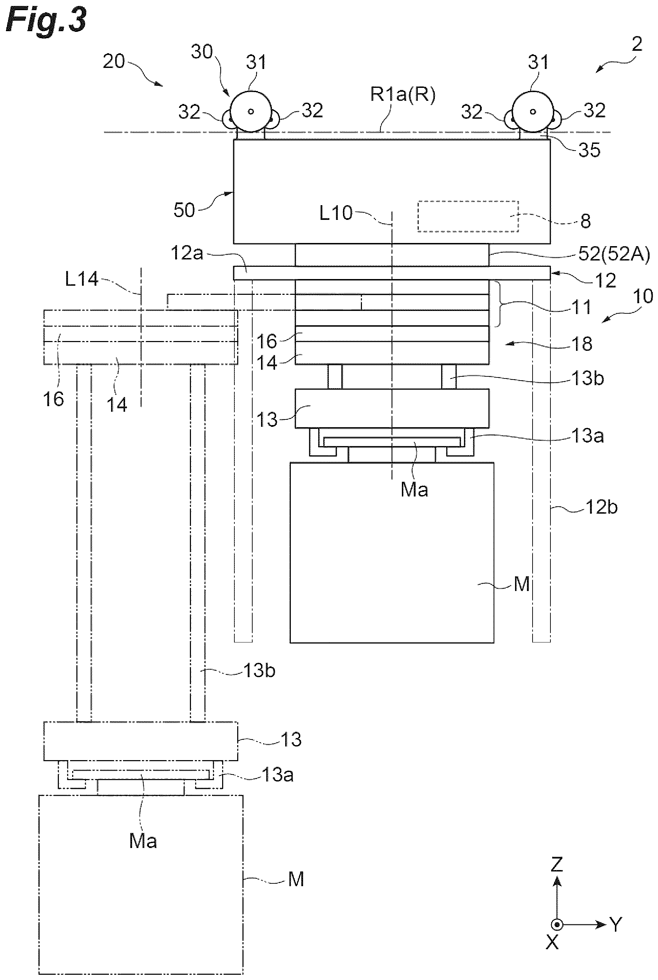

The configuration of the transport vehicle 2 is then described with reference to FIGs. 1, 3 and 4. As illustrated in FIGs. 1 and 3, the transport vehicle 2 is provided to be able to travel along the track R. The transport vehicle 2 has a traveling cart 20 configured to travel on the track R and a body 10 configured to be attached to a bottom part of the traveling cart 20 and can swivel with respect to the traveling cart 20. The traveling cart 20 includes a cart unit 50 of a rectangular shape, for example, disposed below the track R, traveling parts 30 provided at the four corner positions of the cart unit 50 in plan view and protruding upward from the cart unit 50, and four wheel swivel mechanisms 40 configured to swivel the four traveling wheels 31 in the traveling parts 30, respectively, with respect to the cart unit 50. Inside the cart unit 50, a cart controller (control section) 8 is provided.

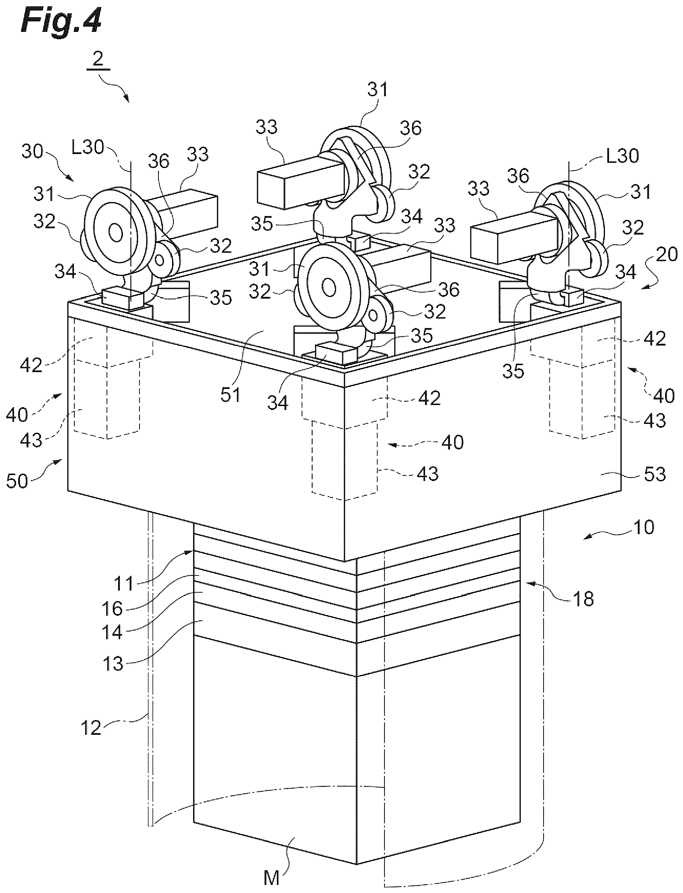

The body 10 is disposed below the track R. As illustrated in FIGs. 3 and 4, the body 10 has a body frame 12 formed in a cylindrical shape, for example. The body frame 12 includes a top panel part 12a of a disc shape and a cylindrical frame 12b hanging from a periphery of the top panel part 12a, and has an open lower surface. The body 10 is formed to have dimensions fitting into one square in the track R (see FIG. 1) in plan view. The transport vehicle 2 can pass another transport vehicle 2 traveling on the adjacent first rail R1 or the adjacent second rail R2. The body 10 includes a transfer device 18 disposed inside the body frame 12. The transfer device 18 has a rectangular shape in plan view, for example. The cylindrical frame 12b is open in part of a circumferential direction. An area in which an open portion (cutout) is formed is large enough to allow the transfer device 18 to pass through. The transfer device 18, when moving horizontally, passes through the open portion of the cylindrical frame 12b.

The body 10 is attached to the bottom part of the cart unit 50 and can swivel around a rotation axis L10 in the Z direction with respect to the cart unit 50. The traveling wheels 31 at the four corner positions of the cart unit 50 are on the track R (on the first travel surface R1a, the second travel surface R2a, or the intersection travel surface R3a). The cart unit 50 is hanged from the track R via the four traveling wheels 31 and the four wheel swivel mechanisms 40. The four traveling wheels 31 allow the cart unit 50 and the body 10 to be hanged stably and the body 10 to travel stably. In other words, the transport vehicle 2 is hanged and supported by the traveling wheels 31 traveling along the track R and moves below the track R.

The transfer device 18 moves horizontally with respect to the body 10 and transfers the articles M to and from a load port (placing platform). The transfer device 18 is provided below the top panel part 12a of the body frame 12. The body 10 including the transfer device 18 is rotatable around the rotation axis L10 by a rotation drive section such as an unillustrated electric motor provided in the top panel part 12a. The transfer device 18 has an article holding section 13 configured to hold an article M on an underside of the track R, a lifting drive section 14 configured to raise and lower the article holding section 13 in the vertical direction, and a slide mechanism 11 configured to slide the lifting drive section 14 in the horizontal direction. The slide mechanism 11 is held on the lower surface of the top panel part 12a. Between the slide mechanism 11 and the lifting drive section 14, a first rotation drive section 16 configured to rotationally drive the lifting drive section 14 with respect to the slide mechanism 11 around the rotation axis L14. The first rotation drive section 16 is provided below the slide mechanism 11, and the lifting drive section 14 is provided below the first rotation drive section 16. The article holding section 13 is provided below the lifting drive section 14 via a plurality of the hanging members 13b. The load port is a transfer destination or a transfer origin of the transport vehicle 2 and a point at which the articles M are transferred to or from the transport vehicle 2.

The article holding section 13 grips a flange part Ma of the article M, thereby hanging and holding the article M. The article holding section 13 is, for example, a chuck having a claw part 13a configured to be movable in the horizontal direction. The article holding section 13 advances the claw part 13a below the flange part Ma of the article M to raise the article holding section 13, thereby holding the article M. The article holding section 13 is connected to the hanging member 13b, such as a wire or belt.

The lifting drive section 14 is, for example, a hoist, the hoist lowering the article holding section 13 by unrolling the hanging member 13b and raising the article holding section 13 by reeling in the hanging member 13b. The lifting drive section 14 is controlled by the cart controller 8 to lower or raise the article holding section 13 at a predetermined speed. In addition, the lifting drive section 14 is controlled by the cart controller 8 to hold the article holding section 13 at a target height.

The slide mechanism 11 has a plurality of movable plates disposed on top of each other in the Z direction, for example. By causing the body 10 to swivel, the slide mechanism 11 moves the first rotation drive section 16, the lifting drive section 14, and the article holding section 13 attached to the lowest movable plate in any desired direction in the horizontal plane. The swivel angle of the body 10 with respect to the cart unit 50 determines the direction of movement of the movable plate in the slide mechanism 11. In the body 10, the orientation of the transfer device 18 and the body frame 12 is set such that the direction of movement of the movable plate and the position of the open portion of the cylindrical frame 12b coincide.

The first rotation drive section 16 includes, for example, an electric motor or the like and rotates the lifting drive section 14 (and the article holding section 13) within a predetermined angular range around the rotation axis L14 extending in the vertical direction. The angle that is rotatable by the first rotation drive section 16 is any desired angle smaller than or equal to 180 degrees, for example, but the upper limit is not limited to 180 degrees. The first rotation drive section 16 allows the article holding section 13 (or the article M held by the article holding section 13) held out sideways to be oriented in any desired direction. The slide mechanism 11 and the first rotation drive section 16 are controlled by the cart controller 8. Note that even when the movable plate of the slide mechanism 11 has not moved and is stowed (in a state indicated by the solid line in FIG. 3), the lifting drive section 14 can be rotated by the first rotation drive section 16. In that case, for example, the rotation axis L14 of the lifting drive section 14 coincides with the rotation axis L10 of the body 10.

The cart unit 50 has a support member 52 of a cylindrical shape (cylindrical member) at the lower end. The top panel part 12a of the body frame 12 is attached in a rotatable manner to the lower surface side of the support member 52. For example, a second rotation drive section 52A, such as an electric motor, is provided in the top panel part 12a. The driving force of the second rotation drive section 52A is transmitted to the support member 52, and thereby the body frame 12 rotates around the rotation axis L10 extending in the vertical direction with respective to the cart unit 50. The angle at which the body frame 12 is rotatable is any desired angle between 360 degrees and 540 degrees, for example, but the upper limit is not limited to 540 degrees and the lower limit is not limited to 360 degrees. The slide mechanism 11 is attached to the lower surface side of the top panel part 12a, and the top panel part 12a supports the slide mechanism 11. The body frame 12 and the transfer device 18 are integrated, and the body frame 12 and the transfer device 18 rotate together. The transport vehicle 2 can receive and deliver the article M to the load port by using the transfer device 18.

A cover 17 is attached to an outer surface side of a cylindrical frame 12b. The cover 17 encloses a transfer device 18 and the article M held in the transfer device 18. The cover 17 has a cylindrical shape with its lower end open and has a cutout shape where the movable plate of a slide mechanism 11 protrudes therefrom (the open portion described above).

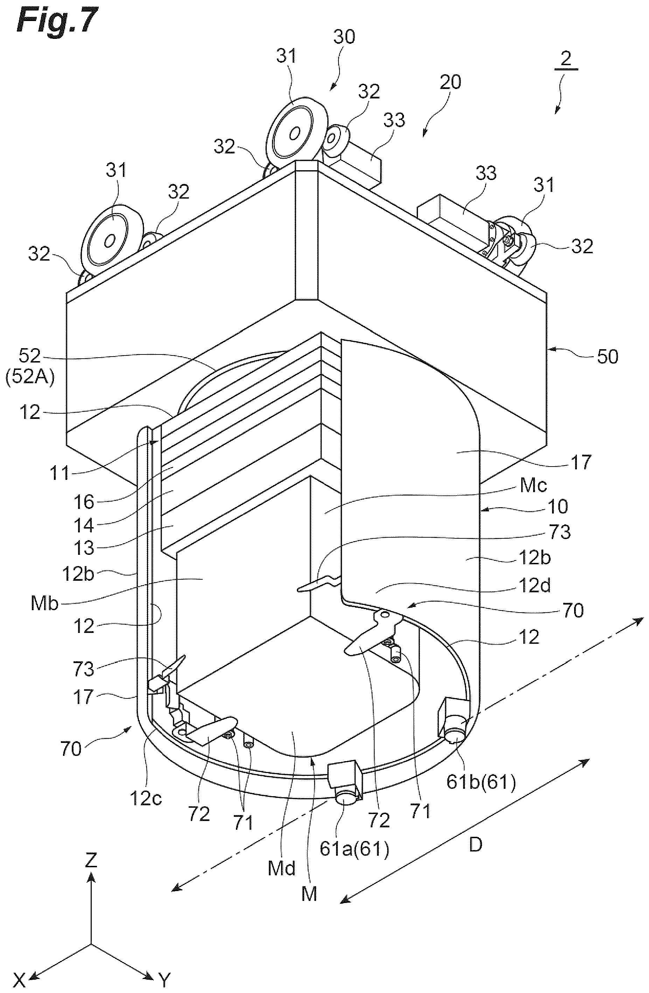

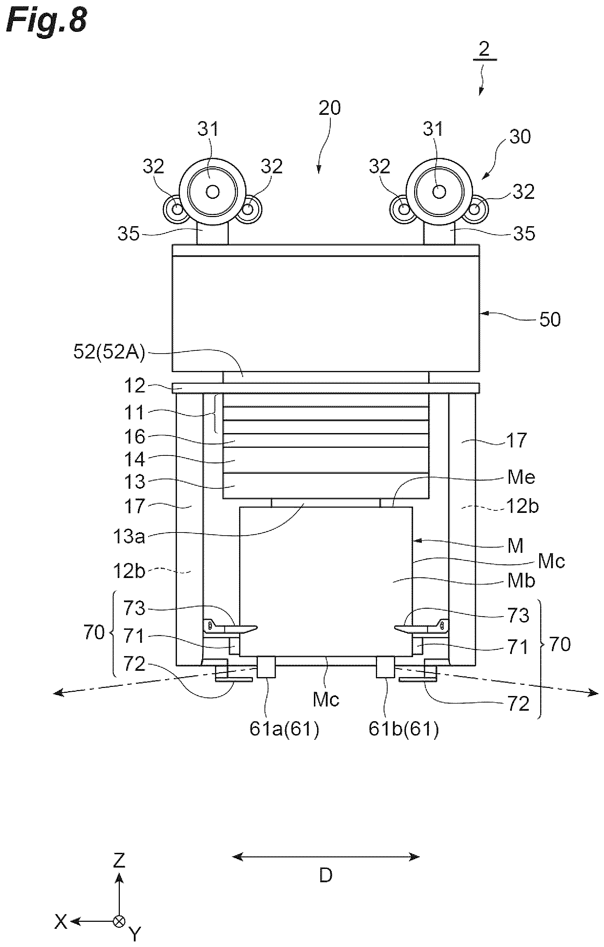

As illustrated in FIGS. 7 and 8, the cylindrical frame 12b is provided with an obstacle sensor 61 configured to detect an obstacle located ahead in a travel direction of a transport vehicle 2 (traveling cart 20). More specifically, the obstacle sensor 61 is provided at a lower part of the cylindrical frame 12b, so as to project downward from the lower end of the cylindrical frame 12b (cover 17). The obstacle sensor 61 is, for example, an optical sensor configured to detect an obstacle by emitting detection light. An emission area of the detection light may be linear, banded, or radial. In addition, the obstacle sensor 61 may be a sensor configured to be capable of detecting a distance from the obstacle sensor 61. The detection result at the obstacle sensor 61 is obtained by a cart controller 8. Note that the obstacle sensor 61 may be disposed in the lower part of the cylindrical frame 12b by cutting out a portion of the lower part of the cover 17, not by protruding downward from the lower end of the cylindrical frame 12b.

The obstacle sensor 61 in the present embodiment includes: a first sensor 61a disposed to be capable of detecting an obstacle on one side of a predetermined direction D in a body part 10; and a second sensor 61b disposed to be capable of detecting an obstacle on the other side of the predetermined direction D. For example, when the body part 10 is swiveled with respect to the traveling cart 20 so that the predetermined direction D in the body part 10 coincides with the X direction, the first sensor 61a detects an obstacle on one side in the X direction, and the second sensor 61b detects the obstacle on the other side in the X direction. Note that as described in detail in the later section, a detection function of one of the first sensor 61a and the second sensor 61b is disabled when the transport vehicle 2 is traveling. Note that the predetermined direction D in the body part 10 indicates an orientation of the body part 10. The orientation of the body part 10 can be based on, for example, a direction along an arrangement of a pair of claws 13a, 13a, a direction along an arrangement direction of a pair of anti-sway members 71, 71, a direction orthogonal to a direction in which a movable plate of the slide mechanism 11 protrudes, or the like.

A detection direction (emission direction of detection light) of the obstacle sensor 61 is directed slightly downward from the horizontal direction, as illustrated in FIG. 8. This allows the obstacle sensor 61 to detect, without detecting other transport vehicles 2, an obstacle that is trying to enter a travel area of the transport vehicle 2 from below in the vertical direction or an obstacle that is entering the travel area of the transport vehicle 2 from below. Note that the obstacles here include some kind of member and a portion or the like of a worker.

The following is an example of a case in which a container with a lid on the front surface (such as FOUP) is transported as an article M. The article M has, in addition to a flange portion Ma, a front surface Mb on which the lid and the like are provided, side surfaces Mc serving as side surfaces other than the front surface Mb, a bottom surface Md serving as the bottom portion, and a top surface Me on which the flange portion Ma is provided. The bottom surface Md has a positioning hole configured to mate, when being placed on the load port, with a positioning pin provided on the load port. To the article M, an orientation of the article M is set based on the direction in which the lid is disposed and the disposition direction of the positioning hole (placement pattern), as described above.

The body part 10 has an article holding mechanism 70 including the pair of anti-sway members 71, 71, a pair of article drop prevention members 72, 72, and a pair of lid drop prevention members 73, 73.

The pair of anti-sway members 71, 71 are provided to prevent the swaying of the article M generated during running by contacting the article M. One of the pair of anti-sway members 71, 71 is provided at a first end 12c in the predetermined direction D of the body part 10, and the other of the pair of anti-sway members 71, 71 is provided at a second end 12d. Each of the pair of anti-sway members 71, 71 is provided to be advanceable to a predetermined position or retractable from a predetermined position, contacting the article M at an advance position and being separated from the article M at a retract position.

Each of the pair of anti-sway members 71, 71 includes two roller members disposed in a direction orthogonal to the predetermined direction D (in the present embodiment, the Y direction). This reduces friction between the pair of anti-sway members 71, 71 and the article M when the pair of anti-sway members 71, 71 advance to the advance position and contact the article M. As described above, for example, when the body part 10 is swiveled with respect to the traveling cart 20 so that the predetermined direction D in the body part 10 coincides with the X direction, the pair of anti-sway members 71, 71 contact the article M in a manner of sandwiching the article M from both ends thereof in the X direction.

The pair of article drop prevention members 72, 72 are provided to prevent the article M from falling downward from the transfer device 18 during traveling. One of the pair of article drop prevention members 72, 72 is provided at the first end 12c in the predetermined direction D of the body part 10, and the other of the pair of article drop prevention members 72, 72 is provided at the second end 12d. Each of the pair of article drop prevention members 72, 72 is provided to be advanceable to a predetermined position or retractable from a predetermined position, and is located below the article M at the advance position and separated from below the article M at the retract position.

The pair of lid drop prevention members 73, 73 are provided to prevent the lid provided onto the front surface Mb from falling below the transport vehicle 2 when the lid comes off. One of the pair of lid drop prevention members 73, 73 is provided at the first end 12c in the predetermined direction D of the body part 10, and the other of the pair of lid drop prevention members 73, 73 is provided at the second end 12d. Each of the pair of lid drop prevention members 73, 73 is provided to be advanceable to the predetermined position or retractable from the predetermined position, and is located ahead of the lid of the article M in the advanced position and separated from the front of the lid of the article M in the retracted position.

The advancement to the advance position and the retract from the retract position for each of the pair of anti-sway members 71, 71, the pair of article drop prevention members 72, 72, and the pair of lid drop prevention members 73, 73 are driven by a single electric motor or the like, which is not illustrated. That is, the pair of anti-sway members 71, 71, the pair of article drop prevention members 72, 72, and the pair of lid drop prevention members 73, 73 advance to the advance position and retreat from the retreat position at approximately the same timing. The pair of anti-sway members 71, 71, the pair of article drop prevention members 72, 72, and the pair of lid drop prevention members 73, 73 and a drive section are connected to each other by link members or the like.

The traveling part 30 has four traveling wheels 31. Each of the traveling wheels 31 is provided with two auxiliary wheels 32. As illustrated in FIG. 4, the traveling wheels 31 are provided at the four corner positions of the cart unit 50 to protrude upward from the upper surface cover 51. Each of the traveling wheels 31 is rotatable around the horizontal or nearly horizontal axle along the XY plane. On a rotation shaft of each of the traveling wheels 31, a traveling drive motor 33 is provided. Each of the traveling wheels 31 is rotationally driven by the driving force of the traveling drive motor 33. The traveling drive motor 33, for example, is configured to be switchable between forward rotation and reverse rotation. Each of the traveling wheels 31 rolls on the track R. Each of the traveling wheels 31 rolls on the travel surfaces R1a, R2a, and R3a of the first rail R1, second rail R2, and intersection rail R3 to drive the transport vehicle 2. It is not limited to that all of the four traveling wheels 31 are rotationally driven by the driving force of the traveling drive motor 33, but there may be a configuration in which some of the four traveling wheels 31 are rotationally driven.

The four wheel swivel mechanisms 40 are fixed to an unillustrated frame inside the cart unit 50, and a base part 34 is connected to each of the wheel swivel mechanisms 40 via a swivel shaft of the wheel swivel mechanism 40. On the base part 34, the traveling wheel 31, the two auxiliary wheels 32, and the one traveling drive motor 33 are attached via a connecting part 35 and a support member 36. For example, an upper surface cover 51 of a square shape is provided on the upper surface of a housing 53, and the base parts 34 are disposed in cutouts formed in the four corners of the upper surface cover 51. The connecting part 35, the traveling wheels 31, the auxiliary wheels 32, and the traveling drive motor 33 are disposed above the upper surface cover 51.

As illustrated in FIGs. 3 and 4, the connecting part 35 connects the cart unit 50 (in detail, the wheel swivel mechanism 40 fixed in the cart unit 50) to the traveling wheels 31. With this connection structure, the cart unit 50 and the body 10 are disposed below the track R and in a state of being hanged from the traveling part 30. The connecting part 35 is formed to be thick enough to pass through the gaps G between the first rail R1 and the intersection rail R3, and between the second rail R2 and the intersection rail R3. The support member 36 is provided in the top part of the connecting part 35 and supports in a rotatable manner the rotation shaft of the traveling wheel 31 and a rotation shaft of the auxiliary wheel 32. The support member 36 holds a relative position of the traveling wheel 31 and the auxiliary wheel 32.

As illustrated in FIG. 4, the traveling wheels 31 are provided in a swivelable manner around a swivel axis L30 extending in the vertical direction. The four swivel axes L30 are disposed at the apexes of a square in plan view, and the rotation axis L10 is placed at the center of the swivel axes L30. In other words, the four swivel axes L30 are disposed on four times symmetrical positions with respect to the rotation axis L10 of the body 10. In plan view, the position of the traveling wheel 31 is different (displaced) from the position of the swivel axis L30. The traveling wheel 31 can swivel by the wheel swivel mechanism 40, and thus can change the traveling direction of the transport vehicle 2.

The auxiliary wheels 32 are disposed one each in front of and behind the traveling wheel 31 in the traveling direction. Each of the auxiliary wheels 32 is rotatable around the axis of a horizontal or nearly horizontal axle along the XY plane. The lower end of the auxiliary wheel 32 is set higher than the lower end of the traveling wheel 31, for example. Therefore, when the traveling wheels 31 are traveling on the travel surfaces R1a, R2a, and R3a, the auxiliary wheels 32 do not contact the travel surfaces R1a, R2a, and R3a. In addition, when the traveling wheels 31 pass through the gaps G between the first rail R1 and the intersection rail R3, and between the second rail R2 and the intersection rail R3, the auxiliary wheels 32 contact the auxiliary members provided on the first rail R1 and the second rail R2 (see below for details) to prevent the traveling wheels 31 from falling. It is not limited to that the two auxiliary wheels 32 are provided on one traveling wheel 31, but one auxiliary wheel 32 may be provided on one traveling wheel 31, for example.

The four wheel swivel mechanisms 40 are disposed, for example, at the four corner positions in the housing 53 of the cart unit 50. Each of the wheel swivel mechanism 40 has a steering motor 43, and a drive force transmission section 42 provided between the steering motor 43 and the traveling wheel 31. The drive force transmission section 42 is fixed to an unillustrated frame inside the cart unit 50. The drive force transmission section 42 is connected to the base part 34 via the swivel shaft. Each of the wheel swivel mechanisms 40 swivels the base part 34, the connecting part 35, the support member 36, the traveling wheel 31, the auxiliary wheel 32, and the traveling drive motor 33 in unison around the swivel axis L30. In a state where the transport vehicle 2 is positioned in the center of each rail unit 100, each of the traveling wheels 31 is swiveled 90 degrees around the corresponding swivel axis L30. Consequently, the traveling wheels 31 swivel on the intersection rail R3. Consequently, the transport vehicle 2 can turn. To turn is to switch from a first state in which the transport vehicle 2 travels in the first travel direction D1 to a second state in which the transport vehicle 2 travels in the second travel direction D2, or from the second state in which the transport vehicle 2 travels in the second travel direction D2 to the first state in which the transport vehicle 2 travels in the first travel direction D1. A turn of the transport vehicle 2 is performed, for example, when the transport vehicle 2 is at a standstill. The turn of the transport vehicle 2 may be performed with the transport vehicle 2 stopped but the articles M moving (for example, swiveling). The drive of the wheel swivel mechanism 40 is controlled by the cart controller 8.

As described above, the gap G is formed in the track R. When the transport vehicle 2 travels on the first rail R1 and crosses the second rail R2, or when the transport vehicle 2 travels on the second rail R2 and crosses the first rail R1, a part of the transport vehicle 2 (in detail, for example, the connecting part 35) passes through the gap G.

Note that between the traveling wheel 31 and the wheel swivel mechanism 40 (for example, near the connecting part 35), the guide roller being in contact with a side of the intersection rail R3 may be provided. The guide roller prevents misalignment of the traveling cart 20 (transport vehicle 2) with respect to the track R.

The transport vehicle 2 includes an unillustrated position detection section configured to detect position information. The position detection section detects the current position of the transport vehicle 2 by, for example, detecting position markers on the track R indicating position information. The position detection section detects position markers in a non-contact manner.

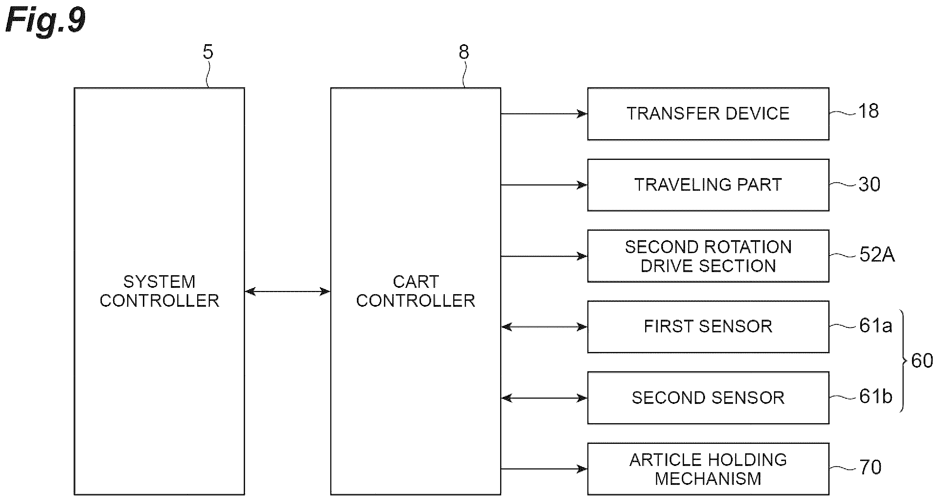

As illustrated in FIG. 3 and 9, the cart controller 8 controls the transport vehicle 2 in an overall manner. The cart controller 8 is a computer including a CPU (Central Processing Unit), ROM (Read Only Memory) and RAM (Random Access Memory), and the like. The cart controller 8 can be configured as software, for example, with which a computer program stored in ROM is loaded onto RAM and executed by the CPU. The cart controller 8 may be configured as hardware using an electronic circuit or the like. The cart controller 8 may include only a single device or include a plurality of devices. If the system includes a plurality of devices, connecting those devices via a communication network, such as the Internet or an intranet logically constructs a single cart controller 8. The cart controller 8 is installed in the cart unit 50, for example.

The cart controller 8 controls the traveling of the transport vehicle 2 based on transport instructions. The cart controller 8 controls the traveling of the transport vehicle 2 by controlling the traveling drive motor 33 and the steering motor 43, and the like. The cart controller 8 controls, for example, travel speed, operations related to stopping, and operations related to direction changes. The cart controller 8 controls the transfer operation of the transport vehicle 2 based on the transfer instructions. The cart controller 8 controls the swiveling (rotation) of the body 10 (the body frame 12 and the transfer device 18), and thereby controls the transfer direction of the transfer device 18. The cart controller 8 controls the transfer operation of the transport vehicle 2 by controlling the transfer device 18 and the like. The cart controller 8 controls the operation of gripping the article M to be disposed at a specified load port, and the operation of unloading the held article M down to a specified load port.

The cart controller 8 controls a traveling drive motor 33 (traveling part 30) based on the detection results of the first sensor 61a or the second sensor 61b. For example, the cart controller 8 controls the traveling drive motor 33 to stop the travel of the traveling cart 20 when an obstacle is detected by the first sensor 61a or the second sensor 61b. When the first sensor 61a and the second sensor 61b are sensors capable of detecting a distance to the obstacle, the traveling drive motor 33 may be controlled to slow the traveling cart 20 when the obstacle is detected within a first distance, and the traveling drive motor 33 may be controlled to stop the traveling cart 20 when the obstacle is detected within a second distance, which is shorter than the first distance.

The cart controller 8, when the traveling cart 20 starts traveling, drives the second rotation drive section 52A to swivel the body part 10 so that the orientation of the article M held in the transfer device 18 is constant with respect to the travel direction of the traveling cart 20. As described above, the articles M have an orientation, and the cart controller 8 swivels the body part 10 so that the front surface Mb where the lid is provided faces a direction orthogonal to the travel direction. The direction orthogonal to the travel direction here may be a leftward direction when the traveling cart 20 is viewed from ahead in the travel direction, or may be a rightward direction.

As illustrated in FIGS. 7 and 8, the cart controller 8 of the present embodiment, when the traveling cart 20 starts traveling, swivels the body part 10 so that the predetermined direction D in the body part 10 coincides with the travel direction (travel direction at the start of traveling), so that the front surface Mb where the lid is provided faces a direction orthogonal to the travel direction. In more detail, the cart controller 8 swivels the body part 10 so that the direction in which the first end 12c and the second end 12d in the body part 10 are aligned approximately coincides with the travel direction, in other words, so that the direction in which the pair of anti-sway members 71, 71 are aligned approximately coincides with the travel direction, or further in other words, so that the detection directions of the first sensor 61a and the second sensor 61b approximately coincide with the travel direction.

The phrase "when the traveling cart 20 starts traveling" here may cover all the aspects when the transport vehicle 2 starts traveling from a stop state, such as when the transport vehicle 2 starts traveling after switching the travel direction thereof at the intersection rail R3, when the transport vehicle 2 starts traveling after completing the transfer work for the article M, or when the transport vehicle 2 starts traveling after performing emergency stop, or may cover, for example, only when the transport vehicle 2 starts traveling after switching the travel direction thereof at the intersection rail R3.

The cart controller 8 swivels the body part 10 so that the detection area (direction of emission of detection light) of one of the first sensor 61a and the second sensor 61b is directed forward in the travel direction of the traveling cart 20 according to the travel direction when the traveling cart 20 starts traveling, and also disables detection of an obstacle in the other of the first sensor 61a and the second sensor 61b. In other words, the cart controller 8 swivels the body part 10 so that one of the first sensor 61a and the second sensor 61b is capable of detecting the obstacle ahead in the travel direction of the traveling cart 20, and makes only one of the first sensor 61a and the second sensor 61b, which is to detect the obstacle ahead in the travel direction, detectable, and the other of the first sensor 61a and the second sensor 61b, which is to detect the obstacle behind in the travel direction, undetectable.

The cart controller 8 determines which one of the detection areas of the first sensor 61a and the second sensor 61b to be directed forward in the travel direction of the traveling cart 20, based on information about in which direction orthogonal to the travel direction the article M is transferred at the next transfer point. For example, the case is assumed where a load port serving as the next transfer point is disposed on the rightward in the travel direction of the transport vehicle 2. In this case, when the traveling cart 20 starts traveling, the body part 10 is swiveled so that a lateral extending direction of the slide mechanism 11 in the transfer device 18 (open portion of the main frame 12) faces rightward in the travel direction. This eliminates the operation of swiveling the body part 10 in a direction in which the load port is disposed when the transport vehicle 2 arrives at the next transfer point.

As illustrated in FIG. 3 and 9, the system controller 5 is a computer including a CPU, ROM and RAM, and the like. The system controller 5 can be configured as software, for example, with which a computer program stored in ROM is loaded onto RAM and executed by the CPU. The system controller 5 may be configured as hardware using an electronic circuit or the like. The system controller 5 may include only a single device or include a plurality of devices. If the system controller 5 includes a plurality of devices, connecting those devices via a communication network, such as the Internet or an intranet logically constructs a single system controller 5. At least some of various controls of the system controller 5 may be performed by the cart controller 8.

The system controller 5 selects any of the transport vehicles 2 configured to be able to transport the articles M and assigns the transport instructions to the selected transport vehicle 2. The transport instructions include a travel instruction causing the transport vehicle 2 to travel to the load port, and an instruction to grab the articles M disposed at the load port or an instruction to unload the articles M being held to the load port.

The effects of the transport vehicle 2 in the above embodiment will be described. In the transport vehicle 2 in the above embodiment, when the body part 10 swivels with respect to the traveling cart 20, the obstacle sensor 61 and the transfer device 18 swivel in unison, and the position of the obstacle sensor 61 does not overlap with the direction in which the transfer device 18 feeds the article M. This eliminates the presence of a support member for attaching the obstacle sensor 6 to the traveling cart 20 in the direction in which the article M is fed from the transfer device 18. As a result, the transfer device 18 is capable of feeding the article M in any direction, increasing the degree of freedom of the transfer position of the article M by the transfer device 18.

The traveling cart 20 of the transport vehicle 2 in the above embodiment moves in the first direction by traveling on the pair of first rails R1, R1 adjacent to each other in the second direction, and moves in the second direction by traveling on the pair of adjacent second rails R2, R2 adjacent to each other in the first direction. In this configuration, it is possible to increase the degree of freedom of the transfer position of the article M by the transfer device 18 while increasing the degree of freedom of the travel direction by the traveling cart 20.

The cart controller 8 of the transport vehicle 2 in the above embodiment swivels the body part 10 so that the detection area of one of the first sensor 61a and the second sensor 61b is directed forward in the travel direction of the traveling cart 20 according to the travel direction when the traveling cart 20 starts traveling, and also disables detection of the obstacle in the other of the first sensor 61a and the second sensor 61b. In this manner, in the configuration of the above embodiment in which the two obstacle sensors 6 (first sensor 61a and second sensor 61b) are provided in the body part 10, compared with the case in which only one obstacle sensor 6 is provided to the body part 10, the time required to swivel the body part 10 so that the detection area of the obstacle sensor 6 faces forward in the travel direction of the traveling cart 20 can be shortened. Consequently, the transport capacity in the transport vehicle 2 can increase.

The cart controller 8 of the above embodiment of the transport vehicle 2 determines which one of the detection areas of the first sensor 61a and the second sensor 61b to be directed forward in the travel direction of the traveling cart 20, based on information about in which direction orthogonal to the travel direction the article M is transferred at a next transfer point. This reduces the time required for swiveling for transfer after arrival at the next transfer point. Consequently, the transport capacity in the transport vehicle 2 can increase.

Although one embodiment is described above, one aspect of the present disclosure is not limited to the above embodiment. Various changes can be made without departing from the intent of the invention.

The transport vehicle 2 in the above embodiment is described with an example in which two sensors, which are the first sensor 61a and the second sensor 61b, are provided as the obstacle sensors 61, but is not limited to this. For example, there may be only one obstacle sensor 61 provided in the body part 10. In this case, the cart controller 8 swivels the body part 10 so that the detection area of the obstacle sensor 61 faces forward in the travel direction of the traveling cart 20 when the traveling cart 20 starts traveling. This allows the obstacle sensor 61, no matter where it is installed in the body part 10, to detect an obstacle located ahead in the travel direction when the transport vehicle 2 is traveling.

The transport vehicle 2 in the above embodiment is described with an example of disabling detection for one of the first sensor 61a and the second sensor 61b, which will detect behind in the travel direction of the traveling cart 20 when the traveling cart 20 starts traveling, but obstacle detection may remain possible. In this case, the cart controller 8 controls the traveling cart 20 (traveling drive motor 33) based on detection information from only one of the first sensor 61a and the second sensor 61b disposed ahead in the travel direction of the traveling cart 20.

The transport vehicles 2 in the above embodiment and the above modification are described with an example of having the article holding mechanism 70 including the pair of anti-sway members 71,71, the pair of article drop prevention members 72,72, and the pair of lid drop prevention members 73,73, but at least one of the pair of anti-sway members 71, 71, the pair of article drop prevention members 72, 72, and the pair of lid drop prevention members 73, 73 may be provided, or none of them may be provided. Even in this case, the orientation of the article M may or may not be constant with respect to the travel direction of the traveling cart 20, for example, with the front surface Mb of the article M facing a direction orthogonal to the travel direction of the transport vehicle 2.

The above embodiment is described with the overhead transport vehicle 2 as an example of a transport vehicle, but AGV (Automated Guided Vehicle) configured to travel on paths in a grid set in advance may be employed, or various known systems traveling on travel paths in a grid may be employed. In addition, the above embodiment is described with the transport vehicle 2 configured to hold the article M below the track R as an example, but the body part 10 may be disposed above the track R and the transport vehicle 2 may hold the article M above the track R.

In addition, the above embodiment and the above modification are described with an example of the track in which the first rail R1 and the second rail R2 are disposed in a grid, as an example of rails on which the transport vehicle 2 travels, but the track may be a track extending in one direction, including branches and merging sections.

### Reference Signs List

- 1: Overhead transport vehicle system
- 2: Overhead transport vehicle (transport vehicle)
- 5: System controller
- 8: Cart controller (control section)
- 10: Body part
- 18: Transfer device
- 20: Traveling cart
- 30: Traveling part
- 50: Cart unit
- 61: Obstacle sensor
- 61a: First sensor
- 61b: Second sensor
- 70: Article holding mechanism
- 71: Anti-sway member
- 72: Article drop prevention member
- 73: Lid drop prevention member
- M: Article
- R: Track
- R1: First rail
- R2: Second rail
- R3: Intersection rail

## Claims

1. An overhead transport vehicle, comprising:
a traveling cart configured to travel on a track;
a body part provided in a swivelable manner with respect to the traveling cart;
a transfer device provided in the body part and provided to be capable of feeding an article in a horizontal direction; and
an obstacle sensor provided in a manner of not overlapping a direction in which the transfer device feeds the article in the body part, and configured to detect an obstacle located ahead in a travel direction of the traveling cart.

2. The overhead transport vehicle according to claim 1, wherein, in the track in which a plurality of first rails extending in a first direction and a plurality of second rails extending in a second direction orthogonal to the first direction are disposed in a grid pattern, the traveling cart moves in the first direction by traveling on the pair of first rails adjacent to each other in the second direction, and moves in the second direction by traveling on the pair of second rails adjacent to each other in the first direction.

3. The overhead transport vehicle of claim 1 or 2, further comprising a control section configured to swivel the body part so that a detection area of the obstacle sensor faces forward in a travel direction of the traveling cart when the traveling cart starts traveling.

4. The overhead transport vehicle according to claim 3, wherein
the obstacle sensor includes: a first sensor disposed to be capable of detecting the obstacle on one side of the body part in a predetermined direction; and a second sensor disposed to be capable of detecting the obstacle on another side in the predetermined direction, and
the control section swivels, according to a travel direction when the traveling cart starts traveling, the body part so that a detection area of one of the first sensor and the second sensor is directed forward in the travel direction of the traveling cart, and disables detection of the obstacle in the other of the first sensor and the second sensor.

5. The overhead transport vehicle according to claim 4, wherein the control section determines which one of the detection areas of the first sensor and the second sensor to be directed forward in a travel direction of the traveling cart, based on information about in which direction orthogonal to the travel direction the article is transferred at a next transfer point.
